(19) Europäisches Patentamt / European Patent Office / Office européen des brevets

(11) **EP 2 255 383 B1**

(12) **FASCICULE DE BREVET EUROPEEN**

(45) Date de publication et mention
de la délivrance du brevet:
**02.01.2019 Bulletin 2019/01**

(21) Numéro de dépôt: **09723285.4**

(22) Date de dépôt: **19.02.2009**

(51) Int Cl.:
*H01L 21/60* *(2006.01)*     *H01L 23/485* *(2006.01)*
*H01L 23/48* *(2006.01)*     *H05K 3/32* *(2006.01)*

(86) Numéro de dépôt international:
**PCT/FR2009/000186**

(87) Numéro de publication internationale:
**WO 2009/115686 (24.09.2009 Gazette 2009/39)**

(54) **COMPOSANT DE CONNEXION MUNI D'INSERTS CREUX ET SON PROCEDE DE REALISATION**

VERBINDUNGSBAUTEIL MIT HOHLEN EINSÄTZEN UND VERFAHREN ZU SEINER HERSTELLUNG

CONNECTION COMPONENT WITH HOLLOW INSERTS AND METHOD FOR MAKING SAME

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **22.02.2008 FR 0851142**

(43) Date de publication de la demande:
**01.12.2010 Bulletin 2010/48**

(60) Demande divisionnaire:
**13163706.8 / 2 618 368**

(73) Titulaire: **Commissariat à l'Énergie Atomique et aux Énergies Alternatives 75015 Paris (FR)**

(72) Inventeurs:
• **MARION, François**
  **F-38950 Saint Martin Le Vinoux (FR)**
• **SAINT-PATRICE, Damien**
  **F-26120 Chabeuil (FR)**

(74) Mandataire: **Cabinet Laurent & Charras Le Contemporain 50 Chemin de la Bruyère 69574 Dardilly Cedex (FR)**

(56) Documents cités:
EP-A- 0 352 020     JP-A- H07 249 632
JP-A- S63 232 450   US-A1- 2004 197 979
US-B1- 6 352 436    US-B1- 6 388 322

EP 2 255 383 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

## DOMAINE DE L'INVENTION

Le domaine technique auquel se rapporte l'invention est celui de la microélectronique, et plus spécifiquement celui de la fabrication, sur tranches de composants semi-conducteurs, de motifs métalliques de forme creuse, cylindriques et biseautés, facilitant par exemple la connexion verticale (mieux connue sous l'expression anglo-saxonne « *flip-chip* ») de deux composants.

La présente invention peut être appliquée à toutes sortes de dispositifs requérant des interconnexions de motifs métalliques à très petit pas, notamment pour la fabrication d'imageurs de très grande dimension à très petits pas.

## ETAT ANTERIEUR DE LA TECHNIQUE

Actuellement, on connaît principalement deux possibilités pour assembler, selon la technique «flip chip par thermocompression», deux composantes nécessitant un grand nombre de liaisons électriques verticales à très petit pas :

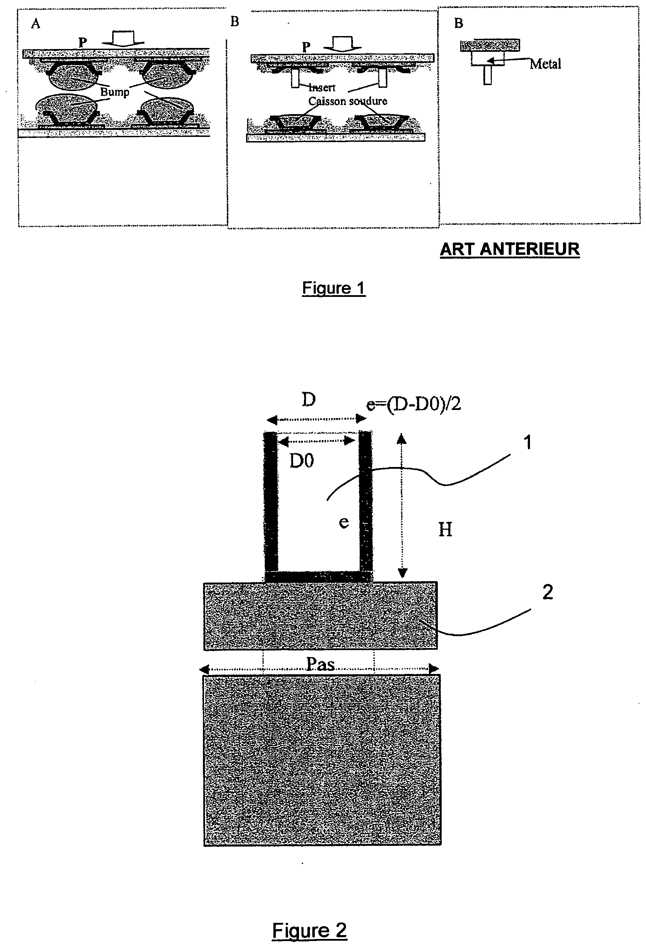

- la première technique de thermocompression consiste à presser, en température, deux billes l'une sur l'autre de manière à les lier par déformation plastique (Fig. 1A).

- la seconde technique, développée pour les pas d'interconnexion les plus fins, permet de travailler à une température plus basse que les températures mises en oeuvre dans la première technique : il s'agit de remplacer l'une des billes thermocompressées par une protubérance « dure » qui casse l'oxyde natif de la soudure à basse température en réduisant la section d'appui (Figure 1B), et permettant ainsi :

    • de réduire la température d'assemblage et la pression d'assemblage ;
    • de contrôler l'écrasement.

Cette seconde technique a fait l'objet de la demande de brevet WO2006/054005 et des inserts adaptés sont décrits dans le document US 6,179,198 (Fig. 1B).

La présente invention s'inscrit dans le cadre de cette deuxième technique, appelée thermocompression par insertion, et tend à résoudre les limitations qui y sont liées, essentiellement au nombre de deux.

Le premier problème est lié aux forces de thermocompression.

En effet, la section de l'insert dans le plan (X, Y) est souhaitée la plus faible possible de manière à limiter la force d'insertion.

Si le nombre de colonnes à insérer augmente, la force d'insertion à exercer sur la pièce à assembler est proportionnelle au nombre $N$ de connexions à réaliser, ainsi qu'à la surface de leur section $S$, selon la formule suivante :

$$F_{hyb} = k*S*N$$

De ce fait, cette technique est limitée pour les composants à très grand nombre de connexions, sachant par exemple qu'une force de 4 tonnes devrait être envisagée pour l'hybridation d'une matrice de 4 millions de pixels (1 g/bump).

Le problème lié à ces forces peut être exacerbé en raison de la sensibilité des composants assemblés.

Ainsi, certains matériaux à assembler sont très sensibles aux contraintes locales, ce qui entraîne la création de dislocations destructrices lors de l'hybridation par thermocompression.

Alternativement, les forces mises en jeu ne sont plus compatibles avec les précisions d'assemblage requises. En effet, le déplacement maximal latéral requis après hybridation doit être inférieur à 1 micromètre.

Le deuxième problème technique important soulevé par la technique de thermocompression par insertion est lié au mode de réalisation des inserts.

En effet, la réalisation de protubérances dans une fonderie semiconducteur peut devenir un problème pour des pas très réduits. Si l'on réduit la section des inserts, les techniques classiques de réalisation peuvent s'avérer difficiles à mettre en oeuvre, de par la finesse des inserts souhaités.

Cette limitation est donc liée à la notion de finesse minimale de photolithogravure. Ainsi, il n'est pas possible de réduire la section d'un insert classique plein, pour une résolution photolithographique technologique donnée $D$, en deçà de la valeur $\pi*D^2/4$.

Les documents JP H07 249632 et US 2004/197979 divulguent des composants munis d'inserts creux utilisés dans un procédé d'assemblage par insertion. Le document JP S63 232450 divulgue un mode de réalisation d'inserts creux.

## EXPOSE DE L'INVENTION

Ayant analysé l'ensemble de ces contraintes spécifiques, le Demandeur propose une solution technique particulière qui consiste à réduire la section d'insertion dans les caissons de soudure, sans toutefois réduire la surface de contact insert/soudure.

En pratique, il s'agit donc d'obtenir un composant, avantageusement une puce, comportant un ensemble d'inserts conducteurs destinés à être connectés électriquement avec un autre composant, lesdits inserts étant creux.

Le fait de remplacer les inserts pleins, décrits dans l'art antérieur, par des inserts creux permet en effet de réduire la section d'insertion.

La présente invention est définie par les revendications ci-jointes.

Selon un premier aspect, la présente invention concerne donc un procédé de réalisation d'un composant de connexion comportant des inserts conducteurs creux cylindriques présentant une extrémité libre biseautée et destinés à être connectés électriquement avec un autre composant. De manière caractéristique, ce procédé comprend les étapes successives suivantes :

- dépôt d'une couche de résine à la surface du composant ;
- réalisation, dans la couche, d'ouvertures cylindriques adaptées à la forme des inserts ;
- dépôt du ou des matériaux constitutifs des inserts suivant la surface de la couche, en vue de former simultanément le corps et le socle des inserts;
- élimination du ou des matériaux sur le plan supérieur de la couche ; le composant étant incliné selon une orientation définie, lors du dépôt du ou des matériaux constitutifs des inserts ou lors de son élimination, de sorte à réaliser des inserts présentant une extrémité libre biseautée;
- retrait de la couche.

La première étape est donc le dépôt d'une couche dite martyr, avantageusement en résine, qui a pour rôle transitoire de servir de matrice pour la formation des inserts et qui est retirée à l'issue du procédé, avantageusement par délaquage.

De manière avantageuse et dans une seconde étape, les ouvertures réalisées dans la couche le sont par photolithographie.

Selon un mode de réalisation privilégié, le dépôt du ou des matériaux constitutifs des inserts suivant la surface de la couche est réalisé à l'aide de techniques de dépôt de couche mince, alors que leur élimination ultérieure, sur le plan supérieur de la couche, est réalisée par gravure.

La solution avantageuse, proposée dans le cadre de la présente invention, est de réaliser un insert creux dont la partie supérieure ou extrémité libre est taillée en biais, formant ainsi un biseau. En d'autres termes, la hauteur H varie aux différents points de la circonférence de l'insert. En pratique et au niveau du procédé faisant l'objet de la présente demande, le composant est incliné selon une orientation définie, soit lors du dépôt du ou des matériaux constitutifs des inserts, soit lors de leur élimination.

De manière privilégiée et dans une étape ultérieure, les surfaces interne et externe de l'insert sont recouvertes d'une couche de métal protégeant de l'oxydation, avantageusement de l'or.

A l'issue d'un tel procédé de fabrication relativement simple de mise en oeuvre, on obtient donc un composant de connexion doté d'inserts conducteurs creux, susceptibles d'être connectés à un second composant. En raison de ce procédé, lesdits inserts présentent la particularité d'être fermés à leur base à l'aide d'un socle reposant à la surface du composant, ledit socle présentant la même composition que le corps de l'insert.

Les inserts creux selon l'invention présentent une section annulaire (notamment ronde ou ovale).

Avantageusement, cette section présente une épaisseur e, dite épaisseur de peau.

Cette forme d'inserts permet de fabriquer ces peaux en mettant en oeuvre des techniques de dépôt de couche mince dérivées des techniques utilisées dans le domaine de la microélectronique et non plus, comme dans des exemples de l'art antérieur, la technique de la photolithographie, dont les inconvénients ont été mentionnés ci-dessus.

Pour illustrer plus avant ce propos, la photolithographie définit une ouverture limitée d'une résine qui va définir la section du futur insert. Ainsi et à titre d'exemple, si D est la limite de résolution de la technologie de photolithogravure, on peut :

- définir un trou qu'on peut remplir par le matériau de l'insert par croissance électrolytique ou par dépôt « *lift off* », l'insert résultant ayant un diamètre égal au diamètre minimum du trou ouvert (minimum D) ;
- déposer une couche du matériau de l'insert et la graver, cette technique étant également limitée par la limite de résolution minimale D.

Il apparaît clairement que la section « efficace » d'un insert suivant l'art antérieur est égale à la surface maximum insérée dans le caisson, soit par exemple en cas d'insert en forme de cylindre de diamètre $\underline{D}$ :
$S = \pi . D^2/4$ avec D : la limite de résolution photolithographique.

Dans le cadre de l'invention, pour une section d'insert équivalente, à savoir un diamètre externe $\underline{D}$, et pour la même résolution photolithographique, la surface d'insertion est définie par la formule suivante :

$$S' = \pi . (D^2 - D0^2)/4 = \pi*2*e*2*D/4$$

soit

$$S' = \pi*e*D$$

dans laquelle e définit l'épaisseur de la peau de l'insert et est très inférieure à D.

Le rapport des surfaces S et S', et donc des forces d'insertion F et F', est au final :

$$F'/F = kS'N/kSN = S'/S$$

soit $F'/F = 4*e/D$ (e<<D)

Par ailleurs et comme déjà précisée, la surface de contact doit être maintenue, voire augmentée.

Or, selon la configuration de l'invention, la surface de contact soudure/insert est *de facto* multipliée par environ deux, puisque aussi bien les surfaces externes qu'internes de l'insert creux sont en contact électrique. En revanche et pour un insert plein, seule la surface externe assure ce contact.

Plus précisément et de manière avantageuse, la protubérance définie dans le cadre de l'invention se présente sous la forme d'un tube fermé à la base par un socle reposant sur le composant, avantageusement une puce.

L'insert creux selon l'invention est réalisé à base de métal pour assurer sa fonction de conduction électrique. Il s'agit avantageusement d'un matériau de dureté supérieure à celle du matériau dans lequel il sera inséré. Par exemple, il peut s'agir de cuivre (Cu), de titane (Ti), de tungstène (W), de WSi, de chrome (Cr) ou d'un multicouche de ces matériaux. Dans ce cas et de manière avantageuse, l'une des couches fait office de couche barrière de diffusion du matériau dans lequel il est inséré : par exemple Ni, Pd, Pt, WN, TiN, etc.

De manière privilégiée et comme déjà dit, les surfaces interne et externe de l'insert sont recouvertes d'une couche de métal protégeant de l'oxydation, avantageusement de l'or.

Selon l'invention, un tel insert creux présente, une extrémité supérieure biseautée.

On entend ici par extrémité supérieure, la partie située à l'opposé de l'extrémité formée par le socle et servant de base d'appui sur le composant. La partie biseautée correspond donc à celle qui est engagée dans l'hybridation avec le second composant, via son insertion dans un plot de connexion.

En effet, il a été constaté, dans le cadre de la présente invention, que l'introduction des protubérances creuses dans les plots pouvait entraîner l'emprisonnement de poches d'air au fond de l'insert.

Une première solution pour remédier à cet inconvénient est de réaliser l'hybridation sous vide.

Une seconde solution avantageuse, proposée dans le cadre de la présente invention, est de réaliser un insert creux dont la partie supérieure ou extrémité libre est taillée en biais, formant ainsi un biseau. En d'autres termes, la hauteur H varie aux différents points de la circonférence de l'insert.

Selon une variante de l'invention, l'insert est inséré dans un autre insert du même type que celui précédemment décrit, et déposé sur l'autre composant avec lequel la connexion est recherchée.

Avec un tel dispositif, un procédé d'hybridation particulier est mis en oeuvre :

- dans une étape de pré-insertion, les inserts creux et biseautés portés par le premier composant sont introduits partiellement dans les plots de connexion du second composant à hybrider. Cette étape est réalisée à l'aide d'une machine de placement standard, ne comportant pas d'appareillage à vide. Elle se déroule avantageusement à température ambiante ;

- l'insertion finale collective est réalisée sous vide dans un simple équipement de pressage, dépourvu de fonctions d'alignement.

Plus généralement et selon un autre aspect, l'invention concerne donc également un procédé d'hybridation entre un composant selon l'invention et un second composant doté de plots de connexion, qui comprend les étapes suivantes :

- alignement et insertion partielle des inserts dans les plots, avantageusement réalisés à température ambiante ;
- insertion finale, avantageusement réalisée sous vide.

Ce procédé en deux temps permet d'éviter la mise en oeuvre de machines et de technologie complexes et coûteuses.

Par ailleurs et comme déjà mentionné, les forces d'insertion mises en jeu sont notablement réduites en raison de l'aspect creux des inserts.

## BREVE DESCRIPTION DES FIGURES

La manière dont l'invention peut être réalisée et les avantages qui en découlent ressortiront mieux de l'exemple de réalisation qui suit, donné à titre indicatif et non limitatif, à l'appui des figures annexées parmi lesquelles :

La figure 1 illustre les différents systèmes de connexion substrat/puce selon l'art antérieur.

La figure 2 schématise une vue en section d'un insert creux reposant, via un socle, sur le composant.

La figure 3 schématise l'hybridation de deux composants via l'insertion d'une protubérance creuse dans le caisson ductile correspondant et illustre l'augmentation de la surface de contact.

La figure 4 schématise les différentes étapes de fabrication d'un composant muni d'inserts creux.

La figure 5 illustre les deux étapes supplémentaires mises en oeuvre lorsque la technique de remplissage - planarisation (mieux connue sous l'expression anglo-saxonne « *gap fill* ») est mise en oeuvre.

La figure 6 schématise une vue en section d'un insert creux et biseauté selon l'invention.

La figure 7 schématise un premier mode de fabrication de composants dotés d'inserts creux biseautés selon l'invention.

La figure 8 schématise un second mode de fabrication de composants dotés d'inserts creux biseautés selon l'invention.

La figure 9 détaille le procédé d'hybridation dans le cas d'un composant doté d'inserts creux et biseautés.

## MODES DE REALISATION DE L'INVENTION

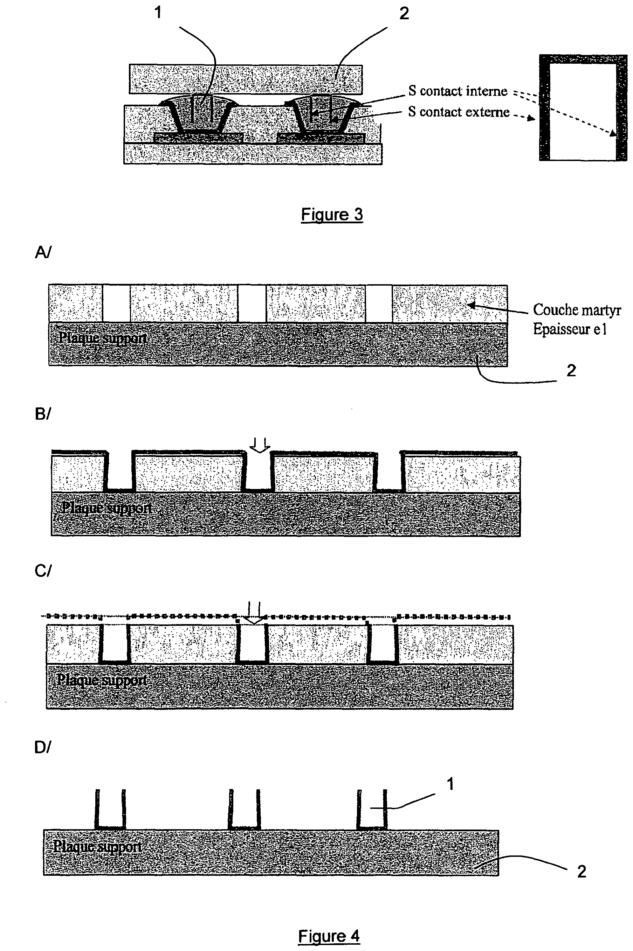

Un composant doté d'inserts creux peut être obtenu à l'aide du procédé illustré à la figure 4. Il s'agit typiquement d'un wafer CMOS (« *Complementary Metal-Oxide Semiconductor* »), issu d'une fonderie silicium.

La première étape (Fig. 4A) consiste à déposer une couche dite «martyr», d'épaisseur $e_1$ et réalisée à l'aide d'une résine. Cette couche est ensuite soumise à une photolithographie standard. Cette étape permet de créer des ouvertures du diamètre souhaité pour les tubes qui serviront d'inserts. Plus généralement, c'est lors de cette étape que la future forme de l'insert est fixée (hauteur, forme de l'ouverture...).

La seconde étape (Fig. 4B) correspond au dépôt du métal, éventuellement une multicouche de métal, correspondant au tube. C'est l'épaisseur de ce dépôt qui dictera l'épaisseur $e$ de l'insert creux. Le métal est avantageusement du cuivre, du titane, du tungstène, du WSi, du chrome ou un multicouche de ces matériaux.

Les diamètres d'ouverture sont maîtrisables à des valeurs inférieures à 1 micromètre et les hauteurs supérieures à 3 micromètres.

Les épaisseurs des métaux sont réglables et contrôlées jusqu'à des valeurs inférieures à 0,1 micromètres.

Il est possible de modifier, ou simplement compléter le dépôt métal habituel par une couche complémentaire d'un métal mouillable, avantageusement de l'or, du platine ou du cuivre. Ceci a pour avantage de faciliter la soudure ultérieure et la création des interfaces intermétalliques nécessaires lors de la soudure finale.

Selon l'invention, l'insert creux prend une forme finale de « tube », correspondant à une ouverture circulaire. Toutefois, dans des exemples qui ne sont pas partie de l'invention, toute autre forme peut être réalisée par une conception adaptée du masque d'ouverture : triangle carré, polygone, etc.

Avantageusement, la forme en creux peut présenter une section de taille variable, et par exemple en forme de cône ou de tronc de cône. Il suffit pour ce faire de jouer sur l'anisotropie de la gravure de la résine martyre.

Il est également possible de combiner des formes différentes sur une même plaque de fabrication et/ou sur une même puce à hybrider.

La troisième étape (Fig. 4C) consiste à retirer la couche métal située sur le plan supérieur de la résine martyre. Deux techniques de gravure de la face métal supérieure peuvent être utilisées :

*1/ Technique de « gravure damascène »*

Cette étape peut être réalisée de la même manière que les gravures damascène utilisées dans l'industrie du semiconducteur. On réalise un polissage mécanique ou mécanochimique de la face supérieure du substrat, la couche métal et une partie de la couche martyre de surface sont retirées, la partie du tube située dans l'ouverture n'étant gravée que sur une portion faible de sa hauteur.

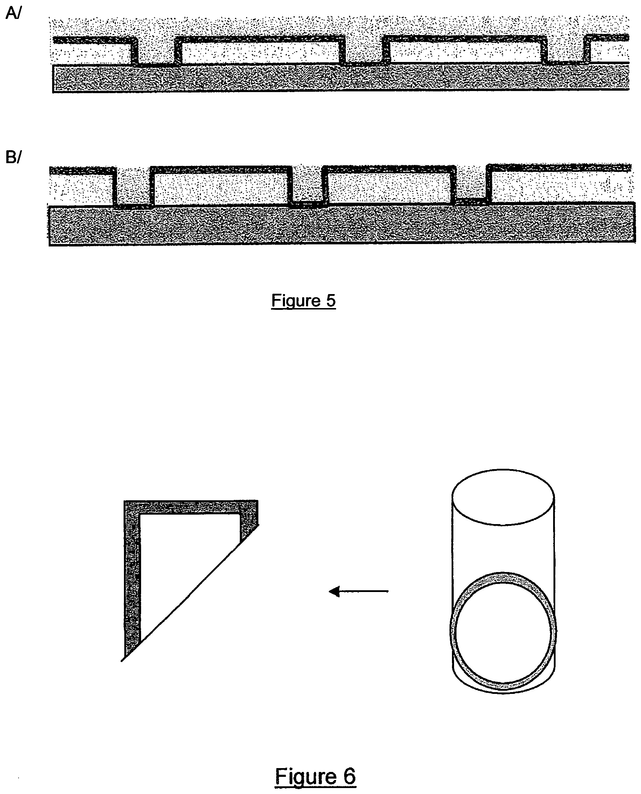

*2/ Technique « gap fill »* (Figure 5)

La plaque issue de l'étape précédente est couverte d'une résine fluide qui vient planariser l'ensemble de la surface et combler les ouvertures, comme illustré à la figure 5A.

La résine est ensuite gravée uniformément sur la plaque (pleine) jusqu'à atteindre la surface de métal supérieure (Fig. 5B). Une détection de fin d'attaque peut aisément être réalisée par analyse optique, analyse de gaz résiduel, etc.

La figure 5B montre que les trous restent remplis de résine en final, du fait de leur forte profondeur et du bon contrôle de l'épaisseur de résine gravée pleine plaque.

Cette configuration est celle présente en sortie d'un masquage classique : on peut réaliser une gravure standard du métal «affleurant», le métal en fond d'ouverture étant toujours protégé par la résine de remplissage.

Un délaquage final de la résine encore présente au fond des ouvertures est ensuite effectué.

La dernière étape (Fig. 4D) correspond au retrait de la couche martyre. Il s'agit d'une étape parfaitement connue de délaquage.

A l'issue de ce procédé, il est possible de compléter la finition interne et externe des inserts par un dépôt de type «*electroless*», qui permet de garantir une non-oxydation postérieure de la surface du métal de l'insert. De l'or est préférentiellement utilisé dans cette étape. A noter que l'or dit «*electroless*» croît sur les zones métalliques exposées des inserts par le phénomène de dépôt « chimique » connu de l'homme du métier.

Ainsi et à titre d'exemple, sachant que la limite de résolution photolithographique d'une fabrique de semiconducteur est de 3 micromètres, pour une épaisseur de résine de 4 micromètres, il est possible de réaliser des tubes présentant les dimensions suivantes :

- hauteur (H) = 3 ($\mu$m ;
- diamètre (D) = 3 $\mu$m ;
- pas = 5 $\mu$m ;
- épaisseur de la peau (e = épaisseur métal couche mince déposée) = 150nm (Ti+TiN+Au).

Un composant doté d'un tel insert est représenté à la figure 2.

Il est possible de calculer le gain en force d'insertion par rapport à un insert cylindrique de même diamètre :

$$F'/F = 4*e/D = 4*0{,}15/3 = 0{,}2.$$

La force d'insertion par insert est donc divisée par 5, en comparaison avec un insert classique de type «cylindre plein». En d'autres termes, il est possible de multiplier par 5 le nombre de connexions, à force de thermocompression égale.

La figure 3 illustre, en outre, l'augmentation de surface de contact qui a lieu à la fois via les surfaces externes de l'insert, mais également via ses surfaces internes.

Selon l'invention, l'insert creux est biseauté dans sa partie supérieure, comme illustré à la figure 6.

Deux procédés, dérivés de celui décrit ci-dessus, permettent d'obtenir un tel biseau.

*1/Fabrication du biseau par gravure*

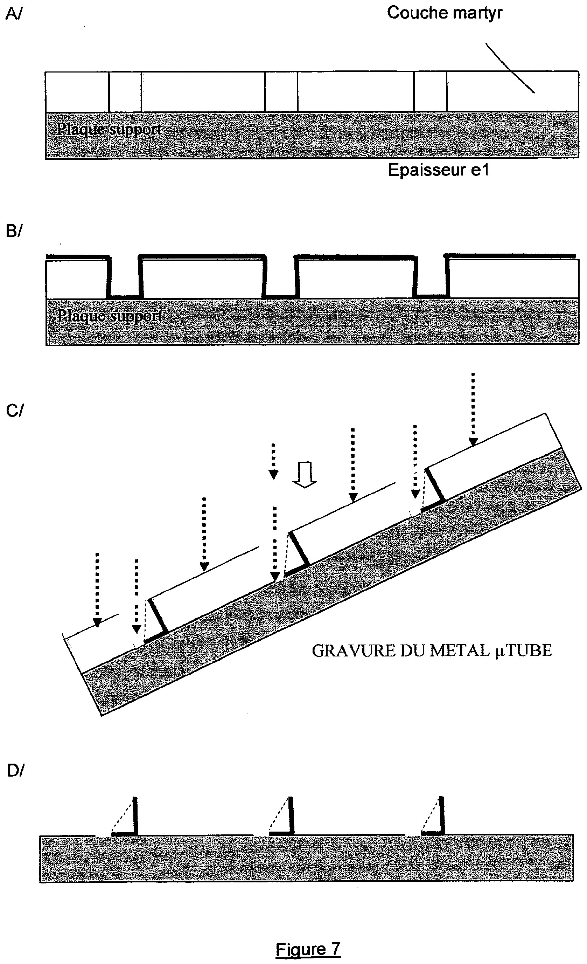

Les première et seconde étapes se déroulent comme décrit plus haut (Fig. 7A et 7B).

En revanche, le procédé est modifié lors l'étape de retrait de la couche métal, couche située sur le plan supérieur et sur le flan. Cette étape est réalisée par gravure « usinage ionique » (ou gravure RIE directive) ou toute autre gravure « directionnelle ».

En pratique, le support plaque est incliné d'un angle contrôlé par rapport à l'angle de gravure.

Ainsi et comme illustré à la Fig. 7C, le métal situé en surface et le métal situé dans le trou, mais non occulté par son flanc, sont gravés.

Le métal du trou situé « à l'ombre » du cône de gravure est conservé. Par exemple, en cas d'usinage ionique, il ne voit pas le faisceau ionique de gravure.

C'est l'angle plaque / direction de gravure qui définit le biseau.

Le retrait de la couche martyre se fait alors de manière classique pour donner la configuration illustrée à la Figure 7D.

*2/ Fabrication du biseau par dépôt*

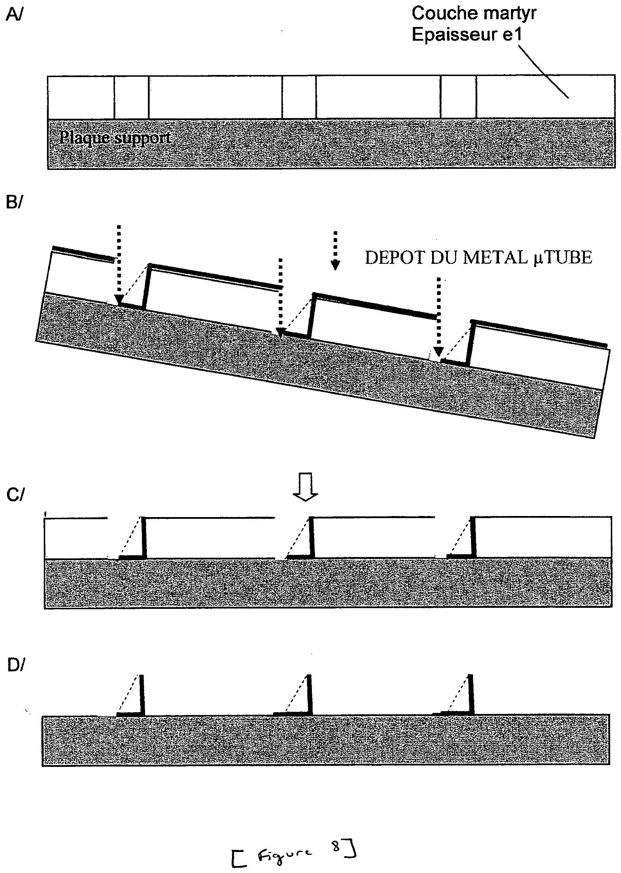

La première étape reste inchangée (Fig. 8A).

En revanche, lors du dépôt du métal (ou du multicouche métal), le support plaque est incliné d'un angle contrôlé par rapport à l'angle d'émission de la source métallique (Fig. 8B). Le dépôt est réalisé par pulvérisation ou évaporation. De fait, la partie du trou située « à l'ombre » du cône de dépôt ne voit pas de dépôt.

L'angle plaque / direction du dépôt définit le biseau.

Dans l'étape suivante (Fig. 8C), le retrait de la couche métal située sur le plan supérieur est réalisé par photolithographie, par procédé CMP damascène, ou procédé « gap fill » comme décrit ci-dessus.

Enfin, dans une ultime étape (Fig. 8D), on réalise le retrait de la couche martyre.

Cette configuration particulière des inserts permet de procéder à l'hybridation des deux composants à connecter électriquement et mécaniquement, en évitant toute formation de bulles d'air.

Un tel procédé se décompose en deux étapes:

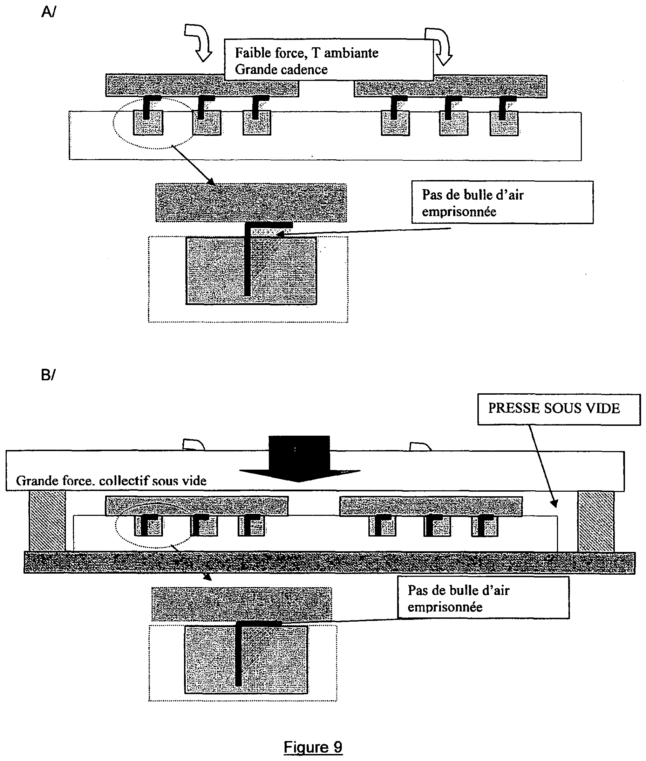

*1/ Prépositionnement précis, rapide, à faible force (Fig. 9A)*

Dans un premier temps, il s'agit de positionner toutes les puces à assembler, par préinsertion à faible force des tubes biseautés, dans les plots de soudure présents sur une face du second composant, à savoir le substrat.

Cette opération peut être réalisée à température ambiante et sous atmosphère standard.

Les puces à assembler sont rendues solidaires de la plaque mère (substrat) par assemblage C2W / « *chip to wafer* » (multihybridation de plusieurs puces sur une même plaque). La force d'insertion est calculée pour que les tubes ne s'insèrent que partiellement en vue de laisser un passage pour un dégazage ultérieur.

*2/ Insertion finale sous vide, à grande force (Fig. 9B)*

La plaque sur laquelle sont disposés des circuits préinsérés est ensuite soumise à une grande force d'insertion, sous vide, afin de permettre l'introduction complète des inserts biseautés creux dans les plots de connexion correspondants.

Les avantages de la présente invention ressortent clairement de la présente demande.

Elle permet de réaliser des hybridations par insertion avec de très faibles forces d'insertion et une surface de contact significativement augmentée (doublée) par rapport à un insert classique.

Ceci permet de réaliser des inserts de très grand rapport de forme inscrits dans des pas d'interconnexion très fins, tout en utilisant des technologies parfaitement maîtrisées dans l'industrie du semi conducteur.

Ainsi, la solution proposée permet de multiplier le nombre de points hybridés, à force d'insertion constante, tout en améliorant en parallèle la résistance d'accès pixel (d'un facteur 2 pour la même limite de résolution photolithographique). En outre, les inserts biseautés écartent tout risque de formation de bulles d'air au niveau de la connexion lors de l'hybridation.

Cette forme d'insert peut également être utilisée pour le composant à connecter. En effet, il existe trois types de connexion :

- l'insert est inséré dans une zone enterrée de l'autre composant ;
- l'insert est inséré dans une protubérance à la surface de l'autre composant ;
- l'insert est inséré dans une protubérance creuse de forme similaire à la sienne. Il suffit alors que les diamètres respectifs soient adaptés : le diamètre intérieur de la protubérance est supérieur au diamètre extérieur de l'insert, ou réciproquement, mais les diamètres respectifs étant cependant suffisamment proches pour assurer le contact, notamment en suite de l'introduction en force de l'insert dans la protubérance.

Afin d'éviter le risque de destruction des inserts en raison de ce mode d'introduction, il est avantageux d'appliquer les principes d'assemblages mécaniques standards. De fait, on préférera des formes complémentaires de type cône/cône, cône/cône inversé, cône/tube. L'assemblage peut ainsi être réversible (connexion/déconnexion).

La présente invention trouve de nombreuses applications, notamment :

- pour les matrices de détection hétérogènes, de grande taille, à grand nombre de connexions par insertion (IRCMOS, CMT refroidis, détecteurs X, etc...) ;
- pour les matrices sensibles à la température hybridées à « froid » ;
- pour les matrices sensibles aux contraintes mécaniques.

## Revendications

1. Procédé de réalisation d'un composant de connexion (2) comportant des inserts conducteurs creux (1) cylindriques, et destinés à être connectés électriquement avec un autre composant, comprenant les étapes successives suivantes :

   - dépôt d'une couche de résine à la surface du composant (2) ;
   - réalisation, dans ladite couche, d'ouvertures cylindriques adaptées à la forme des inserts (1) ;
   - dépôt du ou des matériaux constitutifs des inserts suivant la surface de la couche, en vue de former simultanément le corps et le socle des inserts (1)
   - élimination du ou des matériaux sur le plan supérieur de la couche ;
   - puis retrait de la couche,

   ledit procédé étant **caractérisé en ce que**, lors du dépôt du ou des matériaux constitutifs des inserts ou lors de son élimination, le composant est incliné selon une orientation définie de sorte à réaliser des inserts présentant une extrémité libre biseautée.

2. Procédé de réalisation d'un composant de connexion selon la revendication 1, **caractérisé en ce que** les ouvertures dans la couche de résine sont réalisées par photolithographie.

3. Procédé de réalisation d'un composant de connexion selon la revendication 1 ou 2, **caractérisé en ce que** le dépôt du ou des matériaux constitutifs des inserts (1) suivant la surface de la couche est réalisé à l'aide de techniques de dépôt de couche mince.

4. Procédé de réalisation d'un composant de connexion selon l'une des revendications précédentes, **caractérisé en ce que** l'élimination du ou des matériaux sur le plan supérieur de la couche est réalisée par gravure.

5. Procédé de réalisation d'un composant de connexion selon l'une des revendications précédentes, **caractérisé en ce que** le retrait de la couche est réalisée par délaquage.

6. Procédé de réalisation d'un composant de connexion selon l'une des revendications précédentes, **caractérisé en ce que** dans une étape ultérieure, une couche d'un matériau non oxydable, avantageusement de l'or, est déposée à la surface des inserts (1).

7. Procédé de réalisation d'un composant de connexion selon l'une des revendications précédentes, **caractérisé en ce que** le dépôt constitutif du ou des matériaux constitutifs des inserts (1) comporte le dépôt d'une couche de métal suivie par le dépôt d'une couche complémentaire de métal mouillable.

8. Composant de connexion (2) doté d'inserts conducteurs creux (1), destinés à être connectés électriquement à un autre composant, chaque insert (1) étant fermé à sa base à l'aide d'un socle reposant à la surface du composant (2), ledit socle présentant la même composition que le corps de l'insert (1), **caractérisé en ce que** les inserts (1) sont cylindriques et présentent une extrémité libre biseautée.

9. Composant de connexion selon la revendication 8, **caractérisé en ce que** le ou les matériaux constitutifs de l'insert (1) sont choisis dans le groupe constitué de : Cu, Ti, W, WSi, Cr, Ni, Pd, Pt, WN, TiN.

10. Procédé d'hybridation entre un composant selon la revendication 8 ou 9 et un second composant doté de plots de connexion, comprenant les étapes suivantes :

    - alignement et insertion partielle des inserts (1) ayant une forme de tubes biseautés dans les plots, avantageusement réalisés à température ambiante ;
    - insertion finale, avantageusement réalisée sous vide.

## Patentansprüche

1. Verfahren zum Herstellen eines Verbindungsbauteils (2), das hohle, leitfähige, zylinderförmige Einsätze (1) umfasst, um elektrisch mit einem anderen Bauteil verbunden zu werden, welches die folgenden aufeinanderfolgenden Schritte umfasst:

- Ablagerung einer Harzschicht auf der Oberfläche des Bauteils (2);
- Ausführung in dieser Schicht von zylinderförmigen Öffnungen, die an die Form der Einsätze (1) angepasst sind,
- Ablagerung des Materials oder der Materialien, das bzw. die die Einsätze (1) bildet bzw. bilden, entlang der Oberfläche der Schicht, um gleichzeitig den Körper und den Sockel der Einsätze (1) zu bilden,
- Entfernung des Materials oder der Materialien in der oberen Ebene der Schicht;
- dann Entfernung der Schicht,

wobei dieses Verfahren **dadurch gekennzeichnet ist, dass** bei der Ablagerung des Materials oder der Materialien, das bzw. die die Einsätze (1) bildet bzw. bilden, oder bei seiner Entfernung, das Bauteil in eine festgelegte Richtung geneigt wird, so dass Einsätze hergestellt werden, die ein abgeschrägtes freies Endstück aufweisen.

**2.** Verfahren zum Herstellen eines Verbindungsbauteils gemäß Anspruch 1, **dadurch gekennzeichnet, dass** die Öffnungen in der Harzschicht durch Fotolitografie hergestellt werden.

**3.** Verfahren zur Herstellung eines Verbindungsbauteils gemäß Anspruch 1 oder 2, **dadurch gekennzeichnet, dass** die Ablagerung des Materials oder der Materialien, das bzw. die die Einsätze (1) bildet bzw. bilden, entlang der Oberfläche der Schicht, mit Feinschichtablagerungsverfahrenstechniken ausgeführt wird.

**4.** Verfahren zur Herstellung eines Verbindungsbauteils gemäß einem der vorhergehenden Ansprüche, **dadurch gekennzeichnet, dass** die Entfernung des Materials bzw. der Materialen auf der Oberfläche der Schicht durch Gravur ausgeführt wird.

**5.** Verfahren zur Herstellung eines Verbindungsbauteils gemäß einem der vorhergehenden Ansprüche, **dadurch gekennzeichnet, dass** die Entfernung der Schicht durch Entlackung ausgeführt wird

**6.** Verfahren zur Herstellung eines Verbindungsbauteils gemäß einem der vorhergehenden Ansprüche, **dadurch gekennzeichnet, dass** in einem späteren Schritt eine Schicht nicht oxidationsfähigen Materials, möglichst Gold, auf der Oberfläche der Einsätze (1) abgelagert wird.

**7.** Verfahren zur Herstellung eines Verbindungsbauteils gemäß einem der vorhergehenden Ansprüche, **dadurch gekennzeichnet, dass** die Ablagerung des Materials oder der Materialien, das bzw. die die Einsätze (1) bildet bzw. bilden, die Ablagerung einer Metallschicht, gefolgt von der Ablagerung einer zusätzlichen Schicht benetzbaren Metalls, beinhaltet.

**8.** Verbindungsbauteil, das mit hohlen, leitfähigen, Einsätzen (1) versehen ist, die elektrisch mit einem anderen Bauteil verbunden werden sollen, wobei jeder Einsatz (1) an einer Seite durch einen Sockel verschlossen ist, der auf der Oberfläche des Bauteils (2) sitzt, wobei dieser Sockel dieselbe Zusammensetzung aufweist, wie der Körper des Einsatzes (1), **dadurch gekennzeichnet, dass** die Einsätze (1) zylinderförmig sind und ein freies, abgeschrägtes Endstück aufweisen.

**9.** Verbindungsbauteil nach Anspruch 8, **dadurch gekennzeichnet, dass** das Material oder die Materialien, das bzw. die den Einsatz bildet bzw. bilden, aus der Gruppe ausgewählt werden, die aus Cu, Ti, W, WSi, Cr, Ni, Pd, Pt, WN, TiN besteht.

**10.** Hybridisierungsverfahren zwischen einem Bauteil gemäß Anspruch 8 oder 9 und einem zweiten Bauteil, das mit Verbindungsplots versehen ist, das die folgenden Schritte umfasst:

- Ausrichtung und teilweises Einsetzen der abgeschrägten, rohrförmigen Einsätze (1) in die Plots, am besten bei Zimmertemperatur;
- endgültiges Einsetzen, am Besten im Vakuum.

## Claims

**1.** A method for making a connection component (2) comprising cylindrical hollow conducting inserts (1) to be electrically connected with another component, including the following steps:

- depositing a layer of resin on the surface of the component (2);
- making cylindrical apertures in said layer, that are adapted to the shape of the inserts (1);
- depositing the material or materials constituting the inserts along the surface of the layer, for the purpose of forming simultaneously the body and the plinth of the inserts (1);
- eliminating the material or materials on the upper plane of the layer;
- then removing the layer,

said method being **characterized in that** the component is inclined at a defined orientation during the deposition of the material or materials constituting the inserts (1) or during the elimination thereof, so as to make inserts that have a bevelled free end.

**2.** The method for making a connection component as claimed in claim 1, **characterized in that** the apertures in the resin layer are made by photolithography.

3. The method for making a connection component as claimed in claim 1 or 2, **characterized in that** the material or materials constituting the inserts (1) is deposited along the surface of the layer by means of thin layer deposition techniques.

4. The method for making a connection component as claimed in one of the previous claims, **characterized in that** the materials or materials are eliminated on the upper plane of the layer by etching.

5. The method for making a connection component as claimed in one of the previous claims, chracterized in that the layer is removed by delacquering.

6. The method for making a connection component as claimed in one of the previous claims, **characterized in that** in a subsequent step, a layer of non-oxidizable material, to advantage gold, is deposited on the surface of the inserts (1).

7. The method for making a connection component as claimed in one of the previous claims, **characterized in that** depositing the material or materials constituting the inserts (1) comprises depositing a metal layer and then depositing an additional layer of a wettable metal.

8. Connection component (2) provided with hollow conducting inserts (1), to be electrically connected with another component, each insert being closed at its base by means of a mount resting on the surface of the component (2); the mount having the same composition as the body of the insert, **characterized in that** the inserts are cylindrical in shape and have a bevelled free end.

9. Connection component (2) as claimed in claim 8, **characterized in that** the material or materials constituting the insert (1) are selected from the group comprising: Cu, Ti, W, WSi, Cr, Ni, Pd, Pt, WN, TiN.

10. Hybridization method between a component as claimed in one of claims 8 and 9 and a second component provided with connection bumps, including the following steps:

   - alignment and partial insertion of the inserts (1) having a bevelled tubular shape in the bumps, carried out to advantage at ambient temperature;
   - final insertion, carried out to advantage in a vacuum.

**ART ANTERIEUR**

Figure 1

Figure 2

Figure 3

A/

Couche martyr
Epaisseur e1

B/

C/

D/

Figure 4

A/

B/

Figure 5

Figure 6

A/

Couche martyr

Plaque support

Epaisseur e1

B/

Plaque support

C/

GRAVURE DU METAL µTUBE

D/

Figure 7

A/

Couche martyr
Epaisseur e1

Plaque support

B/

DEPOT DU METAL µTUBE

C/

D/

[ Figure 8 ]

A/

Faible force, T ambiante
Grande cadence

Pas de bulle d'air
emprisonnée

B/

PRESSE SOUS VIDE

Grande force. collectif sous vide

Pas de bulle d'air
emprisonnée

Figure 9

**EP 2 255 383 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006054005 A
- US 6179198 B
- JP H07249632 B
- US 2004197979 A
- JP S63232450 A